(19) Europäisches Patentamt / European Patent Office / Office européen des brevets

(11) **EP 2 770 808 A1**

(12) **DEMANDE DE BREVET EUROPEEN**

(43) Date de publication:
**27.08.2014   Bulletin 2014/35**

(51) Int Cl.:
***H05K 7/14*** (2006.01)

(21) Numéro de dépôt: **14154693.7**

(22) Date de dépôt: **11.02.2014**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité:  **20.02.2013   FR 1351435**

(71) Demandeur: **BULL SAS**
**78340 Les Clayes sous Bois (FR)**

(72) Inventeur: **Demange, Fabien**
**78300 Poissy (FR)**

(74) Mandataire: **Camus, Olivier Jean-Claude**
**Cabinet Camus Lebkiri**
**87, rue Taitbout**
**75009 Paris (FR)**

(54) **Lame de calcul pour serveur montable sur bâti**

(57)   L'invention concerne une lame de calcul (4) pour serveur montable sur bâti (1) comportant :
- un châssis (5) apte à être inséré dans le serveur montable sur bâti (1) suivant un axe de référence (6), le châssis (5) comportant deux faces longitudinales (7, 8) et au moins une face transversale (9);
- deux bras de leviers (17, 18), chaque bras de levier (17, 18) étant fixé au châssis (5) par une liaison pivot (19, 20) de sorte que chaque bras de levier (17, 18) est apte à pivoter par rapport à la face transversale (9) entre une position de verrouillage dans laquelle ledit bras de levier (17, 18) s'étend parallèlement à la face transversale (9) et une position de déverrouillage dans laquelle ledit bras de levier (17, 18) forme un angle α par rapport à la face transversale (9), chaque bras de levier (17, 18) comportant une première extrémité (21, 22) pourvue d'au moins une patte (23, 32) en saillie transversale d'une des faces longitudinales (7, 8) du châssis (5) lorsque ledit bras de levier (17, 18) est dans sa position de verrouillage, les deux bras de levier (17, 18) étant fixés entre eux par une liaison pivot glissant (35).

**Fig. 1**

EP 2 770 808 A1

**Description**

**DOMAINE TECHNIQUE**

La présente invention concerne une lame de calcul pour serveur montable sur bâti pourvue d'un système d'insertion de la lame de calcul dans l'armature du serveur montable sur bâti optimisé.

**ETAT DE LA TECHNIQUE ANTERIEUR**

Les serveurs montables sur bâti comportent généralement plusieurs baies ou emplacements dans lesquels des lames de calcul peuvent être insérées. Le document US 7 684 208 décrit un tel serveur montable sur bâti. Ce serveur montable sur bâti comporte un système de verrouillage permettant de maintenir chaque lame de calcul dans la baie dans laquelle elle est insérée. En outre, ce système de verrouillage comporte un levier permettant à un utilisateur de manipuler la lame de calcul et notamment de l'insérer dans la baie et de la retirer. Toutefois, les leviers de l'art antérieur ne permettent pas de manipuler des lames de calcul de grandes dimensions, ni des lames de calcul dont le poids est important. En particulier, les leviers de l'art antérieur ne permettent pas de manipuler des lames de calcul pourvues d'un système de refroidissement hydraulique car les efforts de connexion sont trop élevés.

Par ailleurs, lors de l'insertion de la lame de calcul dans la baie du serveur montable sur bâti, les connectiques de la lame de calcul doivent être enfichées dans des prises du serveur montable sur bâti. Or les leviers de l'art antérieur ne permettent pas un enfichage correct des connectiques de la lame de calcul sans arc-boutement de la lame de calcul lorsque l'effort de connexion est placé trop loin du point de pivot du levier.

**EXPOSE DE L'INVENTION**

L'invention vise à remédier aux inconvénients de l'état de la technique en proposant des moyens de manipulation d'une lame de calcul qui permette d'insérer et de retirer facilement la lame de calcul d'un serveur montable sur bâti, y compris lorsque la lame de calcul présente un poids et/ou des dimensions importantes, et ce, sans que la lame de calcul ou son système de manipulation ne se déforme.

L'invention vise également à proposer un système d'insertion de la lame de calcul qui permette un bon enfichage des connectiques de la lame de calcul dans le serveur montable sur bâti.

Pour ce faire, est proposé selon un premier aspect de l'invention, une lame de calcul pour serveur montable sur bâti comportant :

- un châssis apte à être inséré dans le serveur montable sur bâti suivant un axe de référence, le châssis comportant deux faces longitudinales et au moins une face transversale;
- des moyens de manipulation de la lame de calcul comportant deux bras de leviers, chaque bras de levier étant fixé au châssis par une liaison pivot de sorte que chaque bras de levier est apte à pivoter par rapport à la face transversale entre une position de verrouillage dans laquelle ledit bras de levier s'étend parallèlement à la face transversale et une position de déverrouillage dans laquelle ledit bras de levier forme un angle $\alpha$ par rapport à la face transversale, chaque bras de levier comportant une première extrémité pourvue d'au moins une patte en saillie transversale d'une des faces longitudinales du châssis lorsque ledit bras de levier est dans sa position de verrouillage, les deux bras de levier étant fixés entre eux par une liaison pivot glissant.

Le fait d'avoir deux bras de levier reliés entre eux par une liaison pivot glissant permet d'avoir des moyens de manipulation de la lame de calcul plus solides que ceux de l'art antérieur. En effet, les efforts sont alors répartis sur les deux bras de levier et sur leurs points de fixation au châssis. Comme chaque liaison pivot comporte deux points d'appui sur le châssis, les efforts des moyens de manipulation sont répartis sur quatre points d'appui du châssis, ce qui évite les arc-boutements de la lame de calcul. En outre, le fait d'avoir une liaison pivot glissant entre les deux bras de levier permet non seulement de renforcer les bras de levier, et de répartir les efforts sur l'ensemble de la lame de calcul, mais cela permet également de n'avoir qu'un bras de levier à manipuler pour insérer ou sortir la lame de calcul du serveur montable sur bâti.

En outre, les moyens de manipulation permettent une insertion optimisée de la lame de calcul dans le châssis, et ils permettent notamment un meilleur enfichage des connectiques de la lame de calcul dans les prises correspondantes du châssis. En effet, les deux bras de levier comportent chacun au moins une patte en saillie transversale du châssis. Lors de l'insertion de la lame, les moyens de manipulation sont en position de déverrouillage et lorsque les pattes des bras de levier se trouvent en face d'encoches correspondantes du serveur montable sur bâti, les bras de levier sont placés en position de verrouillage, de sorte que les pattes pénètrent dans les encoches correspondantes du serveur montable sur bâti et exercent par un effet de levier un effort sur la lame de calcul qui facilite le branchement des connectiques de la lame de calcul dans les prises correspondantes du serveur montable sur bâti. A l'inverse, lorsque l'on veut sortir la lame du serveur montable sur bâti et que l'on place les bras de levier en position de déverrouillage, les pattes exercent un effort dans le sens opposé sur les parois des encoches du serveur montable sur bâti, de sorte qu'elles facilitent la sortie de la lame de calcul du serveur montable sur bâti.

La lame de calcul selon l'invention peut également comporter une ou plusieurs des caractéristiques ci-après prises indépendamment ou selon toutes les combinaisons techniquement possibles.

La liaison pivot glissant est de préférence agencée de façon à ce que l'angle $\alpha$ formé entre un des bras de levier et la face transversale soit toujours égal à l'angle $\alpha$ formé entre l'autre bras de levier et la face transversale. Le fait d'avoir ces deux angles égaux permet d'éviter tout effet d'arc-boutement et de garantir un enfichage parfait de l'ensemble de la connectique quel que soit leur position sur la hauteur de la lame de calcul ou leur force de connexion requise.

Avantageusement, la liaison pivot glissant est formée par :

- une rainure courbe réalisée dans un des bras de levier et

- un pivot solidaire de l'autre des bras de levier, le pivot pouvant coulisser dans la rainure courbe, la rainure courbe présentant une forme agencée pour que l'angle formé entre un des bras de levier et la face transversale soit toujours égale à l'angle formé entre l'autre des bras de levier et la face transversale.

Avantageusement, l'angle $\alpha$ varie entre 0° et 30°. Cet angle est suffisant pour libérer les pattes des orifices du serveur montable sur bâti.

Les bras de levier sont de préférence fixés sur la face transversale du châssis de la lame de calcul.

Avantageusement, la face transversale comporte deux extrémités, chaque bras de levier étant fixé au niveau d'une des extrémités de la face transversale. Ainsi, les efforts de connexion et d'enfichage sont répartis sur toute la hauteur de la lame.

Selon un mode de réalisation préférentiel, un des bras de levier, dit « premier bras de levier », comporte une extrémité libre, l'autre des bras de levier, dit « second bras de levier », comporte une extrémité fixée au premier bras de levier par l'intermédiaire de la liaison pivot glissant. Ainsi, il suffit de manipuler le premier bras de levier pour verrouiller ou déverrouiller les moyens de manipulation de la lame de calcul. La manipulation de la lame de calcul s'en trouve ainsi facilitée malgré la présence des deux bras de levier.

Avantageusement, chaque bras de levier est percé d'ouvertures. Ces ouvertures permettent à l'air de ventilation de pénétrer dans la lame de calcul malgré la présence des bras de levier sur la face transversale du châssis.

Avantageusement, la lame de calcul comporte en outre des premiers moyens de sécurisation aptes à maintenir les bras de levier dans la position verrouillée. Ces premiers moyens de sécurisation permettent d'éviter que la lame de calcul ne sorte du serveur montable sur bâti de manière intempestive. Pour cela, ces premiers moyens de sécurisation comportent de préférence :

- Un crochet flexible fixé sur la face transversale du châssis

- Une pièce de réception du crochet ainsi qu'un bouton à pression sur le premier bras de levier

Dans notre cas, un crochet en matériau flexible, par exemple en tôle acier ressort, est fixé sur la face transversale du châssis. Une pièce de réception du crochet fixée sur le premier bras de levier vient se verrouiller dans le crochet précédent lorsque les bras de levier sont en position de verrouillage. Un bouton est également fixé sur le premier bras de sorte qu'en exerçant une pression, il soulève le crochet flexible de la face transversale du châssis en passant à travers un orifice de la pièce de réception du crochet et libère les bras de levier.

Avantageusement, la lame de calcul comporte en outre des seconds moyens de sécurisation aptes à maintenir les bras de levier dans la position verrouillée. Ces seconds moyens de sécurisation permettent d'éviter que si un utilisateur ne presse par erreur sur le bouton des premiers moyens de sécurisation, les bras de levier puissent pivoter par rapport à la face transversale et libérer ainsi la lame de calcul du serveur montable sur bâti. Pour cela, les seconds moyens de sécurisation comportent de préférence une vis qui traverse un orifice du premier bras de levier et qui peut être vissée dans un orifice de la face transversale du châssis. Lorsque la vis est vissée dans l'orifice de la face transversale du châssis, elle maintient le premier bras de levier en position de verrouillage.

Un deuxième aspect de l'invention concerne également un serveur montable sur bâti comportant une armature dans laquelle une lame de calcul selon le premier aspect de l'invention peut être insérée, l'armature comportant des encoches aptes à recevoir les pattes de chacun des bras de levier de la lame de calcul.

**BREVE DESCRIPTION DES FIGURES**

D'autres caractéristiques et avantages de l'invention ressortiront à la lecture de la description détaillée qui suit, en référence aux figures annexées, qui illustrent :

- La figure 1, une vue en perspective d'un serveur montable sur bâti selon un mode de réalisation de l'invention ;
- La figure 2, une vue en perspective du serveur de la figure 1 lors de l'insertion d'une lame de calcul ;
- La figure 3, une vue en perspective d'une lame de calcul selon un mode de réalisation de l'invention ;
- La figure 4, une vue de côté de la lame de calcul de la figure 3 en position déverrouillée ;
- La figure 5, une vue de côté de la lame de calcul de la lame de calcul de la figure 3 en cours de verrouillage ;
- La figure 6, une vue en perspective des bras de levier de la lame de calcul de la figure 3 ;
- La figure 7, une vue en perspective de la lame de calcul de la figure 3 ;
- La figure 8, une vue de côté d'un des bras de levier de la lame de calcul de la figure 8.

Les éléments identiques ou similaires sont repérés par des signes de références identiques sur l'ensemble des figures.

## DESCRIPTION DETAILLEE D'AU MOINS UN MODE DE REALISATION

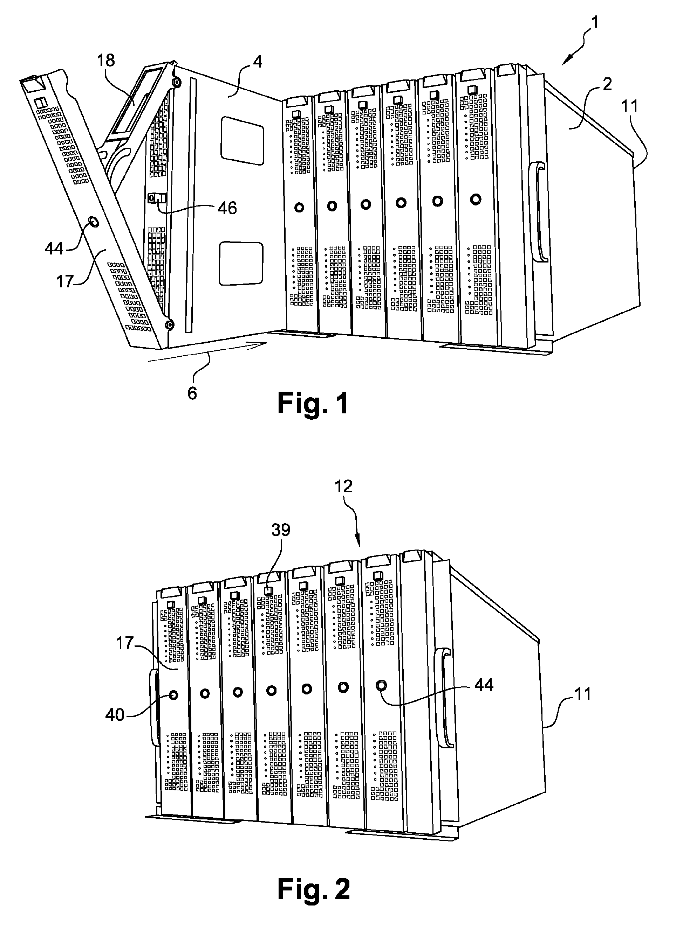

Les figures 1 et 2 représentent un serveur 1 montable sur bâti selon un mode de réalisation de l'invention. Ce serveur 1 comporte une armature 2 comportant elle-même plusieurs baies 3 dans lesquelles des lames de calcul 4 peuvent être insérées. L'armature 2 comporte un fond 11 sur lequel se trouvent des prises dans lesquelles les connectiques des lames de calcul peuvent être branchées. L'armature comporte également une ouverture 12 par laquelle les lames de calcul 4 sont insérées.

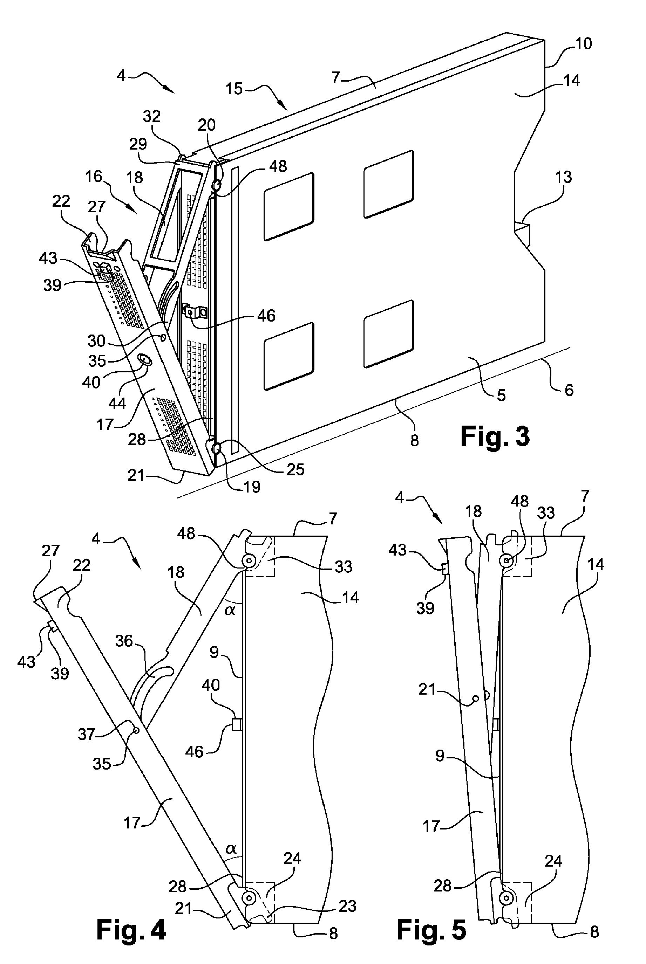

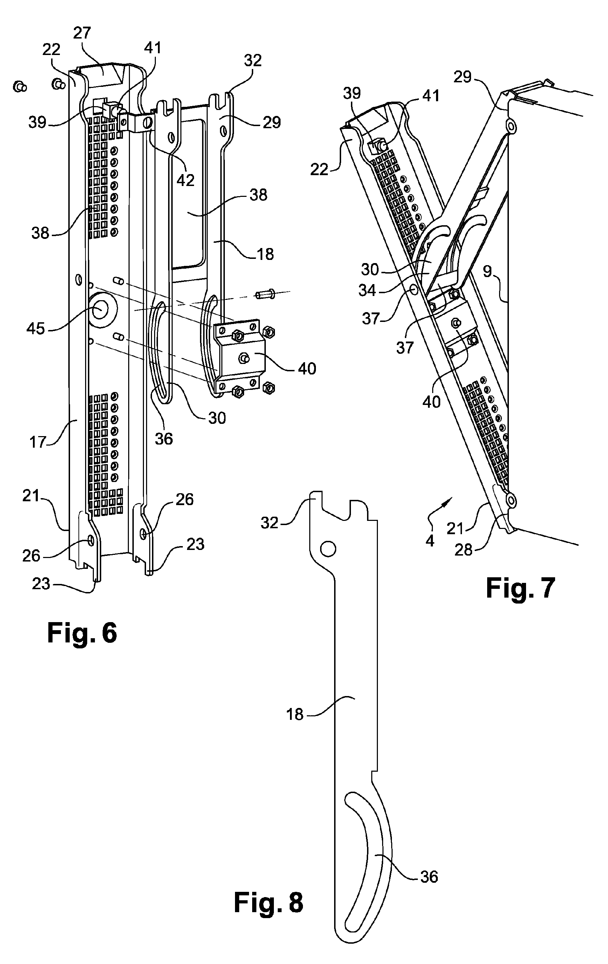

Une lame de calcul 4 est représentée plus précisément sur les figures 3 à 8. Cette lame de calcul 4 comporte un châssis 5. Ce châssis 5 renferme généralement une carte électronique et des composants électroniques (non représentés), ainsi qu'un système de refroidissement, de préférence hydraulique.

La lame de calcul 4 s'étend suivant un axe de référence 6. Cet axe de référence correspond à la direction suivant laquelle la lame de calcul est insérée dans le serveur montable sur bâti.

Le châssis 5 comporte :

- deux faces longitudinales 7, 8 s'étendant suivant l'axe de référence 6 ;
- une face transversale 9 s'étendant perpendiculairement aux deux faces longitudinales 7, 8. Lorsque la lame de calcul 4 est insérée dans l'armature 2, la face transversale 9 se trouve du côté de l'ouverture 12 de l'armature 2 ;
- une face de connexion 10 s'étendant perpendiculairement aux deux faces longitudinales 7, 8. La face de connexion 10 est traversée par des connectiques 13 destinées à être enfichées dans les prises de l'armature 2. Lorsque la lame de calcul 4 est insérée dans l'armature 2, la face de connexion 10 se trouve donc du côté du fond 11 de l'armature 2 ;
- deux parois latérales 14, 15 s'étendant suivant l'axe de référence 6.

La lame de calcul 4 comporte également des moyens de manipulation 16 permettant à un utilisateur d'insérer et de retirer la lame de calcul 4 de l'armature 2. Ces moyens de manipulation 16 comportent :

- Un premier bras de levier 17 fixé au châssis 5 par une liaison pivot 19;
- Un deuxième bras de levier 18 fixé au châssis 5 par une liaison pivot 20.

Chaque bras de levier 17, 18 peut pivoter autour de sa liaison pivot entre :

- Une position de verrouillage (figure 2) dans laquelle le bras de levier est parallèle à la face transversale 9 ;
- Une position de déverrouillage (figure1) dans laquelle le bras de levier forme un angle $\alpha$ non nul avec la face transversale 9.

Les deux bras de levier 17, 18 sont reliés entre eux par une liaison pivot glissant 35 telle que l'angle $\alpha$ formé entre un des bras de levier 17 et la face transversale 9 est égal à l'angle $\alpha$ formé entre l'autre des bras de levier 18 et la face transversale 9.

Plus précisément, le premier bras de levier 17 s'étend sur toute la hauteur de la face transversale 9. Le premier bras de levier 17 comporte une première extrémité 21 et une deuxième extrémité 22. La première extrémité 21 est fixée sur la face transversale 9 par une liaison pivot 19. Plus précisément, la première extrémité 21 du premier bras de levier est de préférence fixée à proximité d'une première extrémité 28 de la face transversale 9. La liaison pivot 21 est de préférence formée par un pivot 25 solidaire de la face transversale 9 et inséré dans deux orifices 26 du premier bras de levier. La première extrémité 21 est en outre pourvue de quatre pattes 23 agencées pour être en saillie transversale de la face longitudinale 8 lorsque le premier bras de levier 17 est en position verrouillée. Les pattes 23 sont en outre agencées pour ne plus être en saillie transversale de la face longitudinale 8 lorsque le premier bras de levier est en position déverrouillée. La lame de calcul comporte également deux renfoncements 24 aptes à recevoir les pattes 23 du premier bras de levier 17 lorsque ledit bras de levier est en position déverrouillée.

La deuxième extrémité 22 du premier bras de levier 17 est libre, et elle présente de préférence un emplacement 27 dans lequel un utilisateur peut introduire son doigt.

Le deuxième bras de levier 18 comporte également une première extrémité 29 et une deuxième extrémité 30. La première extrémité 29 du deuxième bras de levier 18 est fixée par une liaison pivot 20 à la face transversale 9. Plus précisément, cette première extrémité 29 du deuxième bras de levier 18 est de préférence fixée à l'extrémité opposée 48 de la face transversale 9 sur laquelle est fixée la première extrémité 21 du premier bras de levier 17. La liaison pivot entre le deuxième bras de levier 18 et la face transversale 9 est semblable à la liaison pivot entre le premier bras de levier 17 et la face transversale 9. En outre, le deuxième bras de levier comporte également quatre pattes 32 au niveau de sa première extrémité 29, tout comme le premier bras de levier 17. Ces pattes 32 sont en saillie transversale de la face longitudinale 7 lorsque le deuxième bras de levier 18 est en position verrouillée. Le châssis 5 comporte également deux renfoncements 33 agencés pour recevoir chaque patte 32 lorsque le deuxième bras de levier 18 n'est pas en position verrouillée.

Les pattes 23 et 32 sont agencées pour pénétrer dans des encoches de l'armature 2 lorsque la lame de calcul est insérée dans l'armature 2. Ainsi, les pattes 23, 32 permettent de faciliter l'insertion de la lame de calcul dans l'armature 2 et l'enfichage des connectiques de la lame de calcul dans les prises de l'armature 2. En effet, les pattes 23, 32 exercent un effet levier en pénétrant dans les encoches, de sorte qu'elles tirent la lame de calcul vers le fond de l'armature lorsque le premier bras de levier est incliné d'un angle $\alpha$ égal à 30° vers un angle $\alpha$ égal à 0°. Inversement, les pattes 23, 32 exercent un effet de levier en sens inverse lorsque le premier bras de levier 18 est incliné depuis un angle $\alpha$ égal à 0° en direction d'un angle $\alpha$ égal à 30° de sorte qu'elles favorisent la sortie de la lame de calcul de l'armature.

La deuxième extrémité 34 du deuxième bras de levier 18 n'est pas libre mais elle est fixée sur le premier bras de levier 17 par une liaison pivot glissant 35. Plus précisément, la deuxième extrémité 34 du deuxième bras de levier est fixée sur le premier bras de levier au niveau d'un point distant de la deuxième extrémité 22 du premier bras de levier d'une distance égale à la longueur du premier bras de levier.

La liaison pivot glissant 35 est formée par une rainure courbe 36 réalisée dans le deuxième bras de levier 18 et par un pivot 37 solidaire du premier bras de levier, qui vient coulisser dans la rainure courbe 35. La forme de la rainure courbe 35 est choisie de façon à ce que l'angle $\alpha$ entre le premier bras de levier 17 et la face transversale 9 soit toujours égal à l'angle $\alpha$ entre le deuxième bras de levier 18 et la face transversale 9. Ainsi, dans ce mode de réalisation, les coordonnées de la rainure courbe sont les suivantes :

$$X = 10(1-2\sin^2(\alpha))+\sin(\alpha)(311,4\cos(\alpha)-259,6)$$

$$Y = -155,7(1-2\sin^2(\alpha))+\cos(\alpha)(20\sin(\alpha)+259,6)$$

La rainure courbe 35 est en outre dimensionnée de façon à permettre une variation de l'angle $\alpha$ entre 0 et 30°.

La lame de calcul comporte en outre de préférence des premiers et des seconds moyens de sécurisation 39, 40.

Les premiers moyens de sécurisation 39 permettent de maintenir les bras de levier 17, 18 dans la position verrouillée. Pour cela, ces premiers moyens de sécurisation 39 comportent de préférence :

- Une pièce de réception 41 du crochet 42 fixée sur le premier bras de levier 17,
- Un crochet flexible 42 fixé sur la face transversale 9 du châssis 5.

Les moyens de sécurisation comportent en outre de préférence un bouton 43 qui pénètre dans l'orifice la pièce 41 pour soulever le crochet 42. Ainsi, lorsque les bras de levier 17, 18 sont dans la position de verrouillage, le crochet 42 bloque la pièce de réception 41. Le bouton 43 est en position sortie. Une pression sur le bouton 43 fait coulisser le bouton à travers un orifice de la pièce de réception 41 jusqu'à soulever le crochet 42 ce qui permet de libérer le crochet 41 de l'orifice de réception 42, de sorte que les bras de levier 17, 18 sont libres de pivoter par rapport à la face transversale 9.

La lame de calcul comporte en outre des seconds moyens de sécurisation 40 aptes à maintenir les bras de levier 17, 18 dans la position verrouillée. Ces seconds moyens de sécurisation 40 permettent d'éviter que si un utilisateur ne presse par erreur sur le bouton 43 des premiers moyens de sécurisation 39, les bras de levier 17, 18 puissent pivoter par rapport à la face transversale 9 et libérer ainsi la lame de calcul 4 de l'armature 2 du serveur montable sur bâti 1. Pour cela, les seconds moyens de sécurisation 40 comportent de préférence une vis 44 qui traverse un orifice 45 du premier bras de levier 17 et qui peut être vissée dans un orifice 46 de la face transversale 9 du châssis. Lorsque la vis 44 est vissée dans l'orifice 46 de la face transversale 9 du châssis, elle maintient le premier bras de levier 17 en position de verrouillage. En outre, comme le deuxième bras de levier 18 est situé entre le premier bras de levier 17 et la face transversale 9, le deuxième bras de levier 18 est également maintenu en position verrouillée.

Par ailleurs, les deux bras de levier sont de préférence percés par des orifices 38 permettant de laisser passer l'air à travers chaque bras de levier. Les orifices 38 du premier bras de levier sont de préférence nombreux et petits de façon à laisser passer l'air tout en cachant le deuxième bras de levier et la face transversale 9 dans un but esthétique. Les orifices 38 du deuxième bras de levier sont de préférence plus gros pour laisser passer plus d'air et parce que le deuxième bras de levier n'a pas de rôle esthétique.

Naturellement, l'invention n'est pas limitée aux modes de réalisation décrits en référence aux figures et des variantes pourraient être envisagées sans sortir du cadre de l'invention. Ainsi, la liaison pivot glissant pourrait être formée par une rainure sur le premier bras de levier et un pivot fixé sur le deuxième bras de levier au lieu d'avoir la rainure sur le deuxième bras de levier et le pivot fixé sur le premier bras de levier. En outre, chaque extrémité de chaque bras de levier pourrait comporter deux pattes seulement au lieu de quatre, ou alors une seule patte. On pourrait également envisager d'avoir des pattes présentant d'autres formes : par exemple des formes de crochets.

## Revendications

1.  Lame de calcul (4) pour serveur montable sur bâti (1) comportant :

    - un châssis (5) apte à être inséré dans le serveur montable sur bâti (1) suivant un axe de référence (6), le châssis (5) comportant deux faces longitudinales (7, 8) et au moins une face transversale (9);
    - des moyens de manipulation comportant deux bras de leviers (17, 18), chaque bras de levier (17, 18) étant fixé au châssis (5) par une liaison pivot (19, 20) de sorte que chaque bras de levier (17, 18) est apte à pivoter par rapport à la face transversale (9) entre une position de verrouillage dans laquelle ledit bras de levier (17, 18) s'étend parallèlement à la face transversale (9) et une position de déverrouillage dans laquelle ledit bras de levier (17, 18) forme un angle $\alpha$ par rapport à la face transversale (9), chaque bras de levier (17, 18) comportant une première extrémité (21, 22) pourvue d'au moins une patte (23, 32) en saillie transversale d'une des faces longitudinales (7, 8) du châssis (5) lorsque ledit bras de levier (17, 18) est dans sa position de verrouillage, les deux bras de levier (17, 18) étant fixés entre eux par une liaison pivot glissant (35).

2.  Lame de calcul (4) selon la revendication précédente, dans laquelle la liaison pivot glissant (35) est agencée de façon à ce que l'angle ($\alpha$) formé entre un des bras de levier (17) et la face transversale (9) soit toujours égal à l'angle ($\alpha$) formé entre l'autre bras de levier (18) et la face transversale (9).

3.  Lame de calcul (4) selon l'une des revendications précédentes, dans laquelle la face transversale (9) comporte deux extrémités (28, 48), chaque bras de levier (17, 18) étant fixé au niveau d'une des extrémités (28, 48) de la face transversale (9).

4.  Lame de calcul (4) selon l'une des revendications précédentes, dans laquelle un des bras de levier (17), dit « premier bras de levier », comporte une extrémité libre (22), l'autre des bras de levier (18), dit « second bras de levier », comportant une extrémité (30) fixée au premier bras de levier (17) par l'intermédiaire de la liaison pivot glissant (35).

5.  Lame de calcul (4) selon la revendication précédente, dans laquelle la liaison pivot glissant (35) est formée par :

    - une rainure courbe (36) réalisée dans un des bras de levier (18) et
    - un pivot (37) solidaire de l'autre des bras de levier (17), le pivot (37) pouvant coulisser dans la rainure courbe (36), la rainure courbe (36) présentant une forme agencée pour que l'angle ($\alpha$) formé entre un des bras de levier (17) et la face transversale (9) soit toujours égal à l'angle ($\alpha$) formé entre l'autre des bras de levier (18) et la face transversale (9).

6.  Lame de calcul (4) selon la revendication précédente, dans laquelle l'angle $\alpha$ varie entre 0° et 30°.

7.  Lame de calcul (4) selon l'une des revendications précédentes, dans laquelle chaque bras de levier (17, 18) est percé d'ouvertures (38).

**8.** Lame de calcul (4) selon l'une des revendications précédentes, comportant en outre des premiers moyens de sécurisation (39) aptes à maintenir les bras de levier (17, 18) dans la position verrouillée.

**9.** Lame de calcul (4) selon l'une des revendications précédentes, comportant en outre des seconds moyens de sécurisation (40) aptes à maintenir les bras de levier (17, 18) dans la position verrouillée.

**10.** Serveur montable sur bâti (1) comportant une armature (2) dans laquelle une lame de calcul (4) selon l'une des revendications précédentes peut être insérée, l'armature (2) comportant des encoches aptes à recevoir les pattes (23, 24) de chacun des bras de levier de la lame de calcul.

**Fig. 1**

**Fig. 2**

EP 2 770 808 A1

Fig. 3

Fig. 4

Fig. 5

9

**Fig. 6**

**Fig. 7**

**Fig. 8**

EP 2 770 808 A1

**Europäisches Patentamt**
**European Patent Office**
**Office européen des brevets**

# RAPPORT DE RECHERCHE EUROPEENNE

Numéro de la demande

EP 14 15 4693

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | FR 2 779 901 A1 (SEXTANT AVIONIQUE [FR]) 17 décembre 1999 (1999-12-17) * le document en entier * ----- | 1-10 | INV. H05K7/14 |

DOMAINES TECHNIQUES RECHERCHES (IPC)

H05K

Le présent rapport a été établi pour toutes les revendications

| Lieu de la recherche | Date d'achèvement de la recherche | Examinateur |
|---|---|---|
| La Haye | 20 mai 2014 | Benfield, Alan |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

# EP 2 770 808 A1

| Document brevet cité au rapport de recherche | Date de publication | Membre(s) de la famille de brevet(s) | | Date de publication |
|---|---|---|---|---|
| FR 2779901 A1 | 17-12-1999 | CA | 2334997 A1 | 23-12-1999 |
| | | CN | 1305690 A | 25-07-2001 |
| | | DE | 69901109 D1 | 02-05-2002 |
| | | DE | 69901109 T2 | 26-09-2002 |
| | | EP | 1084597 A1 | 21-03-2001 |
| | | ES | 2172992 T3 | 01-10-2002 |
| | | FR | 2779901 A1 | 17-12-1999 |
| | | US | 6695520 B1 | 24-02-2004 |
| | | WO | 9966772 A1 | 23-12-1999 |

EPO FORM P0460

**EP 2 770 808 A1**

## RÉFÉRENCES CITÉES DANS LA DESCRIPTION

**Documents brevets cités dans la description**

- US 7684208 B